Europäisches Patentamt

European Patent Office

Office européen des brevets

(11) Publication number: **0 072 694**
**B1**

# EUROPEAN PATENT SPECIFICATION

(45) Date of publication of patent specification: 03.12.86

(51) Int. Cl.⁴: **H 03 K 19/088,** H 03 K 19/013

(21) Application number: **82304316.1**

(22) Date of filing: **16.08.82**

(54) **Transistor circuit.**

(30) Priority: **17.08.81 JP 128468/81**

(43) Date of publication of application:
**23.02.83 Bulletin 83/08**

(45) Publication of the grant of the patent:
**03.12.86 Bulletin 86/49**

(84) Designated Contracting States:
**DE FR GB**

(56) References cited:
**EP-A-0 026 051**
**EP-A-0 032 043**
**DE-A-2 545 943**
**FR-A-1 548 667**
**US-A-4 132 906**

**PATENTS ABSTRACTS OF JAPAN, vol. 5, no.
198(E-87)(870), 16th December 1981
The New Peguin Dictionary of Electronics,
1979, pages 552-553**

(73) Proprietor: **FUJITSU LIMITED
1015, Kamikodanaka Nakahara-ku
Kawasaki-shi Kanagawa 211 (JP)**

(72) Inventor: **Tanizawa, Tetsu
Daini Yurigaoka-ryo 2-7-5 Chiyokaoka Asao-ku
Kawasaki-shi Kanagawa 215 (JP)**

(74) Representative: **Rackham, Stephen Neil et al
GILL JENNINGS & EVERY 53-64 Chancery Lane
London WC2A 1HN (GB)**

Courier Press, Leamington Spa, England.

## Description

The present invention relates to a transistor circuit such as a transistor-transistor-logic (TTL) circuit, more particularly to a pull-down circuit for an output transistor in the TTL circuit.

A typical TTL circuit comprises a main inverting amplifier composed of transistors, resistors, and a pull-down circuit. The main inverting amplifier receives an input signal and produces an inverted phase signal as its output signal. The pull-down circuit discharges electric charges stored at a base of one of the abovementioned output transistors, when the output transistor is turned from on to off. This shortens the turn-off time. Accordingly, the level of output signal quickly rises from low ("L") to high ("H").

However, a problem with conventional main inverting amplifiers is that the output signal cannot change stepwise from "L" to "H", and vice versa, but changes with a gradual slope. The reasons for this will be explained in detail subsequently but they result in a reduced "noise margin" in the operation of the TTL circuit.

FR—A—1,548,667 describes a transistor circuit comprising a power supply line; a ground line; an input terminal; an output terminal; a phase-inverting transistor having its base connected to the input terminal; first and second output transistors connected to the output terminal, the first and second output transistors being arranged so that they are of opposite conduction state and are turned on and off in response to an output of the phase-inverting transistor; and a pull-down circuit for discharging electric charges stored at a base of the first output transistor comprising a control circuit which has an output node and which generates a signal having the same phase as the input signal at the output node and a two terminal impedance means connected between the base of the first output transistor and the output node of the control circuit.

According to this invention in such a transistor circuit the control circuit includes a control transistor having the same conductivity type as that of the phase-inverting transistor connected to the input terminal, the control transistor being connected between the power supply line and the output node for generating the signal having the same phase as the input signal, and a resistor connected between the output node and the ground line and in that the two terminal impedance means comprises a resistor, a capacitor and a resistor connected in parallel, or a diode and a resistor connected in parallel.

Three particular embodiments of transistor circuits in accordance with this invention will now be described and contrasted with the prior art with reference to the accompanying drawings, in which:—

Figure 1 is a circuit diagram of a typical conventional main inverting amplifier;

Figure 2 is a graph of the output signal from such an amplifier;

Figure 3 is a circuit diagram of a first embodiment of the present invention;

Figures 4A, 4B and 4C illustrate conventional two terminal impedance means, and Figures 4D, 4E and 4F illustrate three examples of a two-terminal impedance means used in the invention;

Figure 5 is a graph of the output characteristics obtained with the present invention;

Figure 6 is a circuit diagram of a second embodiment of the present invention;

Figure 7 is a circuit diagram of a third example of the present invention; and,

Figure 8 is a graph of the output characteristics obtained with the circuit shown in Figure 7.

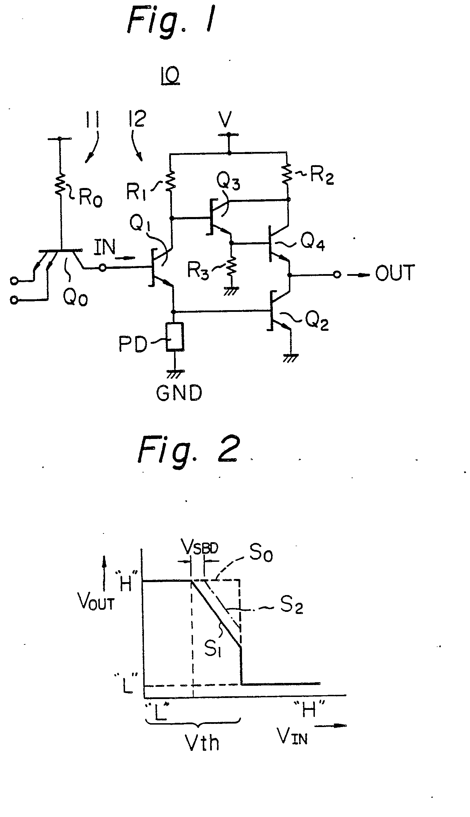

Figure 1 is a circuit diagram of a main inverting amplifier contained in a typical TTL circuit. A similar circuit is disclosed in EP—A—0032043. In Figure 1 TTL circuit 10 is comprised of logic part 11 and main inverting amplifier 12. Main inverting amplifier 12 is conventionally comprised, as shown in Figure 1, of transistors $Q_1$, $Q_2$, $Q_3$, and $Q_4$; resistors $R_1$, $R_2$, and $R_3$; and pull-down circuit PD. Thus, main inverting amplifier 12 produces output signal OUT which is an inverted-phase signal with respect to input signal IN. That is, when the level of input signal IN at phase-inverting transistor $Q_1$ is "H", phase-inverting transistor $Q_1$ and also first output transistor $Q_2$ are turned on. At the same time, transistor $Q_3$ and second output transistor $Q_4$ are turned off. The level of output signal OUT thereby changes to "L". On the other hand, when the level of input signal IN is "L", phase-inverting transistor $Q_1$ and also first output transistor $Q_2$ are turned off. At the same time, transistors $Q_3$ and $Q_4$ are turned on. The level of output signal OUT thereby changes to "H".

Pull-down circuit PD discharges electric charges stored at the base of first-output transistor $Q_2$ when the transistor is turned from on to off. This shortens the turn-off time. Accordingly, the level of output signal OUT quickly rises from "L" to "H".

A function similar to the above-mentioned function of pull-down circuit PD is also achieved by resist $R_3$. Resistor $R_3$ discharges electric charges stored at the base of second output transistor $Q_4$ when the transistor is turned from on to off. This shortens the turn-off time. Accordingly, the level of output signal OUT quickly falls from "H" to "L".

Pull-down circuit PD is constructed as a two-terminal unit, for example, simply as a resistor, as is resistor $R_3$ for transistor $Q_4$. However, there is a problem with such a pull-down circuit. Since the resistor comprising pull-down circuit PD is connected between ground GND and first output transistor $Q_2$ at its base and phase-inverting transistor $Q_1$ at its emitter, current can freely flow through the resistor. Therefore, when the level of input signal IN rises from "L" to "H" and, thereby, phase-inverting transistor $Q_1$ starts turning from off to on, the current starts flowing through the resistor (pull-down circuit PD). Consequently, even though phase-inverting transistor $Q_1$ starts

turning on, it cannot supply current to the base and emitter of first output transistor $Q_2$ fast enough after turning on since current passes to circuit PD. In this case, it cannot supply base current to first output transistor $Q_2$ until the voltage drop across pull-down circuit PD exceeds base-emitter voltage $V_{BE2}$, for example, 0.6 V to 0.8 V, of first output transistor $Q_2$. Thus, phase-inverting transistor $Q_1$ starts supplying current even when first output transistor $Q_2$ is still off, that is, the level of output signal OUT still remains at the "H" level. At this time, a voltage drop across resistor $R_1$ is created by the current flowing through phase-inverting transistor $Q_1$, now on. This voltage drop, on the other hand, reduces voltage level $V_{OUT}$ of output signal OUT. Voltage level $V_{OUT}$ is represented by the expression

$$V - V_{R1} - V_{BE3} - V_{BE4},$$

where the symbol V denotes a source voltage, $V_{BE3}$ and $V_{BE4}$ denote, respectively, base-emitter voltages of transistors $Q_3$ and $Q_4$, and $V_{R1}$ denotes the voltage drop across resistor $R_1$. Therefore, voltage level $V_{OUT}$ of output signal OUT is necessarily reduced due to increase of value $V_{R1}$ when transistor $Q_1$ starts turning on.

Figure 2 is a graph used for explaining the problem arising in the circuit of Fig. 1. Since main inverting amplifier 12 of Fig. 1 is basically an inverter, voltage level $V_{OUT}$ should ideally be changed stepwise along dotted line $S_0$ in Fig. 2 from "H" to "L", and vice versa, in accordance with the change of voltage level $V_{IN}$ of input signal IN from "L" to "H", and vice versa. However, voltage level $V_{OUT}$ does not change stepwise, but changes in a gradual slope such as shown by solid line $S_1$ in Fig. 2. This is because, as previously mentioned, voltage drop $V_{R1}$ increases when transistor $Q_1$ starts turning on. It should be noted that such a sloping change (curve $S_1$) of voltage level $V_{OUT}$ reduces the noise margin. That is, it cannot clearly be distinguished voltage level $V_{OUT}$ is "H" or "L" when voltage level $V_{IN}$, varies at levels corresponding to said slope. The threshold voltage seen from logic part 11 (Fig. 1) must preferably be as large as shown by symbol $V_{th}$ (Fig. 2). However, the presence of the slope makes the threshold voltage lower than the preferable one ($V_{th}$). This makes the noise margin in the operation of the TTL circuit very small.

It is possible to minimize said slope by employing a series circuit made of both a resistor and Schottky barrier diode (SBD) for pull-down circuit PD. In this case, the slope can be minimized to curve $S_2$ shown in Fig. 2. Since the addition of the SBD to said resistor keeps the collector current of phase-inverting transistor $Q_1$ from flowing until voltage level $V_{IN}$ of input signal IN increases enough to turn on the SBD, that is, forward voltage $V_{SBD}$ of the SBD exceeds about 0.4 V. Until that happens, no voltage drop occurs across resistor $R_1$ and, accordingly, voltage level $V_{OUT}$ of output signal OUT, now "H", cannot be reduced. When voltage level $V_{IN}$ increases enough to turn on the SBD, voltage drop occurs across resistor $R_1$ and voltage level $V_{OUT}$ of output signal OUT is reduced. Soon after this, transistor $Q_2$ is turned on, and, therefore, output signal OUT changes to the level of "L".

As mentioned above, the input-output characteristics of the main inverting amplifier (see 12 of Fig. 1) can be slightly improved by adding an SBD to said resistor. However, this still leaves an undesired slope as shown by chain dotted curve $S_2$ in Fig. 2. Setting the forward voltage of the SBD higher than, for example, 0.4 V, would further minimize the undesired slope and enable its elimination, however, this would leave no way to discharge the electric charges from the base of first output transistor $Q_2$ when it turns off.

The degree of the slope is determined by the ratio between the resistance value of resistor $R_1$ and the resistance value of the resistor contained in pull-down circuit PD. If the resistance value of the latter is increased, the slope may be made relatively flat, however, this would obstruct the function of pull-down circuit PD. If the resistance value of the latter is decreased, the function of pull-down circuit PD may be made sufficient, however, this would create a considerable slope. This in turn would reduce the noise margin in the operation of the TTL circuit and, at the same time, increase the power loss when input signal IN is at the "H" level.

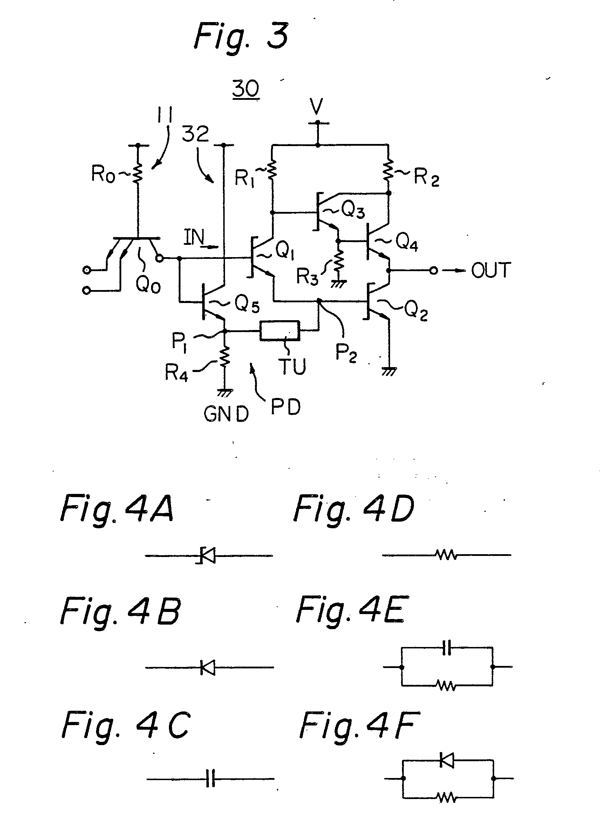

The present invention provides an improved pull-down circuit PD, wherein the input-output characteristics show the desired stepwise change. Figure 3 is a circuit diagram of a TTL circuit according to a first embodiment of the present invention. In Fig. 3, members similar to those of Fig. 1 are represented by the same reference symbols and numerals as those of Fig. 1. TTL circuit 30 is comprised of logic part 11 and main inverting amplifier 32. Reference symbol $Q_0$ represents a multi-emitter transistor in logic part 11. Logic part 11 is provided at its input side with, for example, on OR or AND logic circuit (not shown) and forms, with main inverting amplifier 32, a NOR gate or NAND gate. Reference symbol $Q_1$ represents the phase-inverting transistor, $Q_2$ the first output transistor, and $Q_4$ the second output transistor. Transistor $Q_3$ is a Darlington connection transistor together with second output transistor $Q_4$. Thus, phase-inverting transistor $Q_1$ acts as a logic part of the TTL circuit, and transistors $Q_1$, $Q_2$, $Q_3$ and $Q_4$ act as a main inverting amplifier thereof. As seen from Figure 3, pull-down circuit PD according to the first embodiment is comprised of, first, two-terminal unit (impedance means) TU and, second, a control circuit made of control transistor $Q_5$ and resistor $R_4$ connected in series therewith. Thus, a signal having the same phase as input signal IN is produced at a junction point between transistor $Q_5$ and resistor $R_4$ at one terminal of two-terminal unit TU. The other terminal thereof receives the signal having the same phase as input signal IN. Therefore, the pull-down function is effective only when the pull-down circuit is to be operated. The operation of pull-down circuit PD will be clarified hereinafter.

Figures 4A, 4B, 4C, 4D, 4E, and 4F illustrate six examples of two-terminal unit TU of Figure 3. Figure 4A illustrates a SBD, Figure 4B a diode, and Figure 4C a capacitor. These are all conventional. Two-terminal impedance units TU in accordance with the present invention are shown in Figures 4D, E and F with Figure 4D showing a resistor, Figure 4E a parallel circuit of a resistor and a capacitor, and Figure 4F a parallel circuit of a resistor and a diode.

In the TTL circuit of Figure 3, when voltage level $V_{IN}$ of input signal IN changes from "H" to "L", a transistor $Q_1$ is turned from on to off and transistor $Q_5$ is also turned off. Simultaneously, the pull-down operation is achieved with the aid of two-terminal unit TU and resistor $R_4$, which operation is substantially the same as that of pull-down circuit PD of Figure 1. As a result, first output transistor $Q_2$ is turned off, and output signal OUT of the "H" level is obtained. In this case, the electric charges stored at the base of first output transistor $Q_2$ are smoothly discharged to ground GND via two-terminal unit TU and resistor $R_4$, thus first output transistor $Q_2$ is quickly turned off.

In the above case, voltage level $V_{IN}$ of input signal IN is often higher when it indicates logic "L" than base-emitter voltage $V_{BE5}$ of transistor $Q_5$. In such a case, transistor $Q_5$ will finally turn on and, therefore, the electric charges at the base of transistor $Q_5$ cannot be discharged via two-terminal unit TU and resistor $R_4$. Thus, the desired pull-down operation may not be achieved. However, actually, transistor $Q_5$ is momentarily turned off during the fall of voltage level $V_{IN}$. Therefore, the electric charges at the base of first output transistor $Q_2$ are momentarily discharged when transistor $Q_5$ is off. This is because the voltage level at the emitter of transistor $Q_5$ cannot quickly follow the fall of voltage level $V_{IN}$. Accordingly, since input signal IN usually varies quickly, first the base level at the base of transistor $Q_5$ falls, and then, after a certain delay time, the voltage level at the emitter thereof falls. Consequently, transistor $Q_5$ can momentarily be turned off during such a delay time.

Contrary to the above, when voltage level $V_{IN}$ of input signal IN changes from "L" to "H" (and, therefore, the slope shown in Fig. 2 occurs, since transistor $Q_5$ functions as an emitter follower, a voltage level having the same level as input signal IN appears at junction point $P_1$. Strictly speaking, the voltage level at junction point $P_1$ is lower that that of input signal IN by the value of the base-emitter voltage of transistor $Q_5$. Therefore, no current flows through two-terminal unit TU (the reason for this will be explained in the next paragraph), and phase-inverting transistor $Q_1$ remains off and is not turned on until first output transistor $Q_2$ is turned on. Consequently, no voltage drop $V_{R1}$ occurs across resistor $R_1$ until first output transistor $Q_2$ is turned on. This means that no voltage fall of output signal OUT is created during the transient term from level "L" to "H" of input signal IN. As a result, no slope is created.

To be more specific, when voltage level $V_{IN}$ of input signal IN changes from "L" to "H", junction point $P_1$ and junction point $P_2$ (corresponding to respective terminals of two-terminal unit TU), reduce voltages lower than voltage level $V_{IN}$ of input signal IN by base-emitter voltage $V_{BE1}$ of transistor $Q_1$ and by base-emitter voltage $V_{BE5}$ of transistor $Q_5$, respectively. Therefore, if the equation $V_{BE1}=V_{BE5}$ stands, the voltage levels at junction points $P_1$ and $P_2$ are the same. Thus, no current flows through two-terminal unit TU. In other words, in the above state, pull-down circuit PD can be disregarded and the aforementioned voltage fall of output signal OUT, which induces the slope shown in Fig. 2, no longer occurs. In this case, strictly speaking, a current may flow through transistor $Q_1$ and two-terminal unit TU toward ground GND, the current creating the balance of

$$V_{BE1}+V_{TU}=V_{BE5}$$

($V_{TU}$ denotes a voltage drop across two-terminal unit TU created by the current). However, it should be noted that such a current-balancing current is very small and is negligible. That is, the voltage levels at junction points $P_1$ and $P_2$ are, as mentioned above, almost the same.

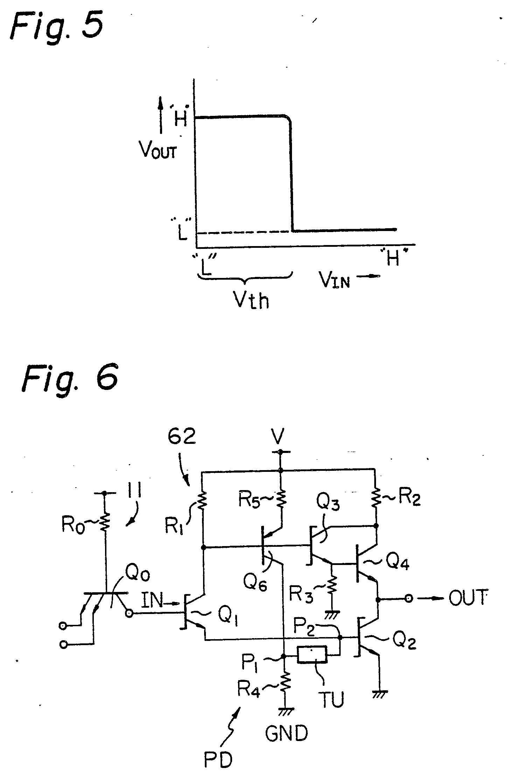

Figure 5 is a graph representing the input-output characteristics obtained by the circuit shown in Fig. 3. The curve of Fig. 5 includes no slope as shown in Fig. 2. With reference to both Figs. 3 and 5, when the voltage level of input signal IN is "H", the voltage levels at junction points $P_1$ and $P_2$, which are each adjacent to a terminal of two-terminal unit TU, are the same as previously explained. To be more specific, the voltage level at junction point $P_2$ is higher than the level of ground GND by $V_{BE2}$, the base-emitter voltage of first output transistor $Q_2$. Voltage level $V_{IN}$ of input signal IN is clamped to a level higher than the level at junction point $P_2$ by $V_{BE1}$, the base-emitter voltage of transistor $Q_1$. On the other hand, the voltage level at junction point $P_1$ is lower than voltage level $V_{IN}$ by $V_{BE5}$, of the base-emitter voltage of transistor $Q_5$. In this case, the base-emitter voltages of these transistors are usually the same value, i.e., $V_{BE}$. Accordingly, the voltage levels at junction points $P_1$ and $P_2$ are both higher than the level of ground GND by $V_{BE}$. In such a state, when voltage level $V_{IN}$ of input signal IN changes from "H" to "L", the voltage level at junction point $P_1$ changes to the ground level via resistor $R_4$. At this moment, the voltage level at junction point $P_2$ is still maintained higher than the ground level by $V_{BE}$ due to the presence of electric charges stored at the base of first output transistor $Q_2$, which is conductive because of input signal IN of the "H" level. During the above-mentioned term, a current flows through two-terminal unit TU and resistor $R_4$ toward ground GND. As a result, the stored electric charges at the base of first output transistor $Q_2$

can quickly be discharged with the flow of said current.

If the diode of Fig. 4A or 4B is employed for realizing two-terminal unit TU of Fig. 3, a current can flow through the diode until the voltage at junction point $P_2$ reaches forward voltage $V_f$ of the diode. This current is not a long-term, continuous current, but a short-term current. In this case, when transistor $Q_5$ is not still completely turned off, said voltage level at junction point $P_2$, that is $V_f$, should be replaced with $V_{INL} - V_{BE5} + V_f$, where $V_{INL}$ denotes the "L" level of input signal IN. As mentioned above, even though said current is not a long-term current, but a short-term current, the short-term current is enough for discharging at least the stored electric charges at the base of first output transistor $Q_2$. Further, it should be noted that since the diode has a static capacity (that is, a so-called p—n junction capacity), the stored electric charges, at least, can be discharged with the charging current for said static capacity when the voltage level of input signal IN changes to the "L" level.

If the resistor of Fig. 4D is employed for two-terminal unit TU, it is difficult to obtain a function for discharging the stored electric charges, especially during said transient term. However, it is easy to discharge the stored electric charges, after which the voltage level difference between points $P_1$ and $P_2$ finally reaches a constant large value. From such a viewpoint, the parallel circuit of both the resistor and the capacitor, as shown in Fig. 4E, is preferable for two-terminal unit TU. In conclusion, it is most preferable that two-terminal unit TU be composed of the parallel circuit of both the resistor and the diode, as shown in Fig. 4F, because the diode is necessarily provided with the static capacity.

Figure 6 is a circuit diagram of a TTL circuit according to a second embodiment of the present invention. In Fig. 6, members similar to those of Fig. 3 are represented by the same reference symbols and numerals as those of Fig. 3. As seen from Fig. 6, pnp transistor $Q_6$ is newly employed instead of npn transistor $Q_5$ of Fig. 3. However, the operational principle of main inverting amplifier 62 in Fig. 6 is substantially the same as main inverting amplifier 32 in Fig. 3. In the second embodiment, a signal having the same phase as that of input signal IN is produced at junction point $P_1$ between two-terminal unit TU and resistor $R_4$ by way of pnp transistor $Q_6$. That is, when the level of input signal IN is "H", phase-inverting transistor $Q_1$ is turned on. Therefore, pnp transistor $Q_6$ is also turned on and the "L" level appears at junction point $P_1$. This means that the signal at junction point $P_1$ has the same phase as that of input signal IN. Contrary to the above, when the level of input signal IN changes from "L" to "H", phase-inverting transistor $Q_1$ starts turning on. At this time, a current would start flowing through two-terminal unit TU and resistor $R_4$ toward ground GND. However, such a current suddenly stops flowing because when the level at

junction point $P_2$ rises, due to the turning on of phase-inverting transistor $Q_1$, the level at junction point $P_1$ also rises due to the turning on of transistor $Q_6$. Thus, phase-inverting transistor $Q_1$ cannot be turned on until first output transistor $Q_2$ is turned on. This means no undesired slope is created in the curve of output signal OUT when it changes from "H" to "L", as in the circuit of Fig. 3.

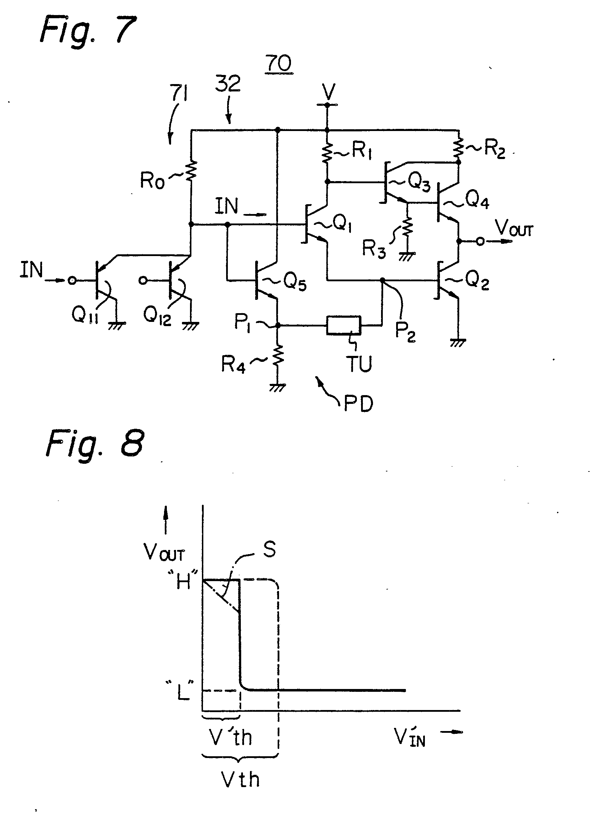

Figure 7 is a circuit diagram of another example of a TTL circuit to which the present invention is adapted. Figure 8 is a graph representing the input-output characteristics obtained by the circuit shown in Fig. 7. TTL circuit 70, comprised of logic part 71 and main inverting amplifier 32, is an example of a TTL circuit in which by the present invention is particularly advantageous. In Fig. 7, logic part 71 is comprised of pnp transistors $Q_{11}$ and $Q_{12}$ and resistor $R_0$, rather than multi-emitter transistor $Q_0$ and resistor $R_0$ as in logic part 11 of Fig. 3.

As previously explained, according to the present invention, the prior art characteristic curves $S_1$ and $S_2$ of Fig. 2 can be improved, so as to obtain the stepwise characteristic curve shown in Fig. 5. This enables a considerably increased threshold voltage $V_{th}$ of input signal IN, used for determining the boundary of transition in "H"→"L" or "L"→"H" of voltage level $V_{OUT}$ of output signal OUT. This means an enlarged noise margin in the operation of the TTL circuit. The threshold voltage $V_{th}$ shown in Fig. 5 is about $2 \times V_{BE}$.

In TTL circuit 70, since logic part 71 is comprised of pnp transistors $Q_{11}$ and $Q_{12}$, threshold voltage $V_{th}'$ (see Fig. 8) of input signal IN' is lower than threshold voltage $V_{th}$ (see Figs. 5 and 8) of input signal IN. Therefore, in Fig. 8, if the undesired slope in the input-output characteristic curve is measured, as in curves $S_1$ and $S_2$ of Fig. 2, there would be almost no noise margin (refer to chain-dotted slope S in Fig. 8). However, according to the present invention, even though the threshold voltage is as low as voltage $V_{th}'$, the noise margin can still be maintained, because the input-output characteristic curve changes stepwise.

As mentioned above, according to the present invention, since the pull-down circuit is operated selectively only when it is required, the input-output characteristics of the main inverting amplifier are improved and the noise margin can be increased. Further, since the slope of Fig. 2 no longer exists, it is not necessary to take the resistance value of resistor $R_4$ into account in determining the resistance value of resistor $R_1$ (because, as previously mentioned), the inclination degree of said slope is usually determined by the ratio between the resistance values of resistors $R_1$ and $R_4$). Accordingly, the resistance value of resistor $R_1$ is determined independently from that of resistor $R_4$, which means increased flexibility in design work. Further, it is possible to increase the resistance value of resistor $R_1$, because resistor $R_1$ is irrelevant to resistor $R_4$. If the resistance value of

resistor $R_1$ is large, resistor $R_4$ is not needed to absorb, toward the ground, a large current therefrom. In other words, resistor $R_4$ can absorb a large amount of the stored electric charges at the base of transistor $Q_2$, and, thereby, transistor $Q_2$ can quickly be turned from on to off. Thus, a sharp rising edge from "L" to "H" of output signal OUT can be realized.

**Claim**

A transistor circuit comprising a power supply line; a ground line; an input terminal; an output terminal; a phase-inverting transistor (Q1) having its base connected to the input terminal; first (Q2) and second (Q4) output transistors connected to the output terminal, the first and second output transistors being arranged so that they are of opposite conduction state and are turned ON and OFF in response to an output of the phase-inverting transistor (Q1); and a pull-down circuit (PD) for discharging electric charges stored at a base of the first output transistor (Q2) comprising a control circuit which has an output node (P1) and which generates a signal having the same phase as the input signal at the output node (P1) and a two terminal impedance means (TU) connected between the base of the first output transistor (Q2) and the output node (P1) of the control circuit (Q5), characterised in that the control circuit includes a control transistor (Q5) of the same conductivity type as that of the phase-inverting transistor (Q1) connected between the power supply line and the output node (P1) for generating the signal having the same phase as the input signal, and a resistor (R4) connected between the output node (P1) and the ground line, and in that the two terminal impedance means (TU) comprises a resistor (Figure 4D), a capacitor and a resistor connected in parallel (Figure 4E), or a diode and a resistor connected in parallel (Figure 4F).

**Patentanspruch**

Transistorschaltung mit einer Energie-versorgungsleitung; einer Erdleitung; einem Eingangsanschluß; einem Ausgangsanschluß; einem Phasenumkehrtransistor (Q1), dessen Basis mit dem Eingangsanschluß verbunden ist; ersten (Q2) und zweiten (Q4) Ausgangstransistoren, die mit dem Ausgangsanschluß verbunden sind, wobei die ersten und zweiten Ausgangstransistoren so angeordnet sind, daß sie von entgegengesetztem Leitungszustand sind und, in Abhängigkeit von einem Ausgang des Phasenumkehrtransistors (Q1), EIN und AUS geschaltet werden; und einer Pull-down-Schaltung (PD) zum Entladen elektrischer Ladungen, die bei einer Basis des ersten Ausgangstransistors (Q2) enthalten sind, welche eine Steuerschaltung umfaßt, die einen Ausgangsknoten (P1) hat une ein Signal erzeugt, das dieselbe Phase wie das Eingangssignal bei dem Ausgangsknoten (P1) hat, und eine Zweipol-Impedanzeinrichtung (TU), die zwischen der Basis des ersten Ausgangstransistors (Q2) und dem Ausgangsknoten (P1) der Steuerschaltung (Q5) angeschlossen ist, dadurch gekennzeichnet, daß die Steuerschaltung einen Steuertransistor (Q5), der von demselben Leitfähigkeitstyp wie der des Phasenumkehrtransistors (Q1) ist und zwischen der Energieversorgungsleitung und dem Ausgangsknoten (P1) zur Erzeugung des Signals angeschlossen ist, das dieselbe Phase wie das Eingangssignal hat, und einen Widerstand (R4) umfaßt, der zwischen dem Ausgangsknoten (P1) und der Erdleitung angeschlossen ist, und daß die Zweipol-Impedanz-einrichtung (TU) einen Widerstand (Figur 4D), einen Kondensator und einen parallel geschalteten (Figur 4E) Widerstand, oder eine Diode und einen parallel geschalteten (Figur 4F) Widerstand umfaßt.

**Revendication**

Circuit à transistors comprenant une ligne d'alimentation électrique; une ligne de terre; une borne d'entrée; une borne de sortie; un transistor d'inversion de phase (Q₁) dont la base est connectée à la borne d'entrée; un premier transistor de sortie (Q₂) et un deuxième transistor de sortie (Q₄) connectés à la borne de sortie, les premier et deuxième transistors de sortie étant disposés de façon qu'ils soient dans des états de conduction opposés et soient rendus conducteur et non conducteur en réponse à un signal de sortie du transistor d'inversion de phase (Q₁); et un circuit de tirage vers le bas (PD) qui décharge les charges électriques emmagasinées sur la base du premier transistor de sortie (Q₂), comprenant un circuit de commande qui possède un noeud de sortie (P₁) et qui produit un signal ayant la même phase que le signal d'entrée sur le noeud de sortie (P₁) et un moyen d'impédance à deux bornes (TU) se connectant entre la base du premier transistor de sortie (Q₂) et le noeud de sortie (P₁) du circuit de commande (Q₅); caractérisé en ce que le circuit de commande comporte un transistor de commande (Q₅) ayant le même type de conductivité que le transistor d'inversion de phase (Q₁) et connecté entre la ligne d'alimentation électrique et le noeud de sortie (P₁) afin de produire un signal ayant la même phase que le signal d'entrée, et une résistance (R₄) connectée entre le noeud de sortie (P₁) et la ligne de terre, et en ce que le moyen d'impédance à deux bornes (TU) comprend une résistance (figure 4D), un condensateur et une résistance connectés en parallèle (figure 4E), ou une diode et une résistance connectés en parallèle (figure 4F).

# Fig. 1

# Fig. 2

1

## Fig. 3

## Fig. 4A

## Fig. 4B

## Fig. 4C

## Fig. 4D

## Fig. 4E

## Fig. 4F

*Fig. 5*

*Fig. 6*

## Fig. 7

## Fig. 8

4